# EUROPEAN PATENT APPLICATION

(11) **EP 2 117 121 A1**
(43) Date of publication of application: **11.11.2009**
(21) Application number: 08103832.5
(22) Date of filing: 06.05.2008
(51) Int. Cl.: H03K 17/567, H03K 17/04, H03K 17/12

(54) **Semiconductor power switch**

(71) Applicant: Schleifring und Apparatebau GmbH, 82256 Fürstenfeldbruck (DE)
(72) Inventor: Klemt, Michael, 80999 München (DE); Krumme, Nils, 82340 Feldafing (DE)
(74) Representative: Lohr, Georg

(57) **Abstract**

A Semiconductor power switch comprises one first lGBT (1) and at least one second lGBT (2). The collectors of both IGBTs and also the emitters of both IGBTs are connected to each other. The first IGBT (1) is an IGBT type with comparatively low collector-emitter on voltage and comparatively high turn on or turn off switching energy. In contrast thereto the second IGBT (2) is an IGBT type with comparatively high collector-emitter on voltage and comparatively low turn on or turn off switching energy. Both IGBTs receive gate signals from a control circuit (10) for switching the power switch on during a first time interval and off during a second time interval. The control circuit (10) is designed to deliver an on signal to the second IGBT (2) during the whole first time interval and an on signal to the first IGBT (1) during only parts of the first time interval.

## Description

### FIELD OF THE INVENTION

The invention relates to a semiconductor power switch, based on IGBTs and a related power converter.

### DESCRIPTION OF THE PRIOR ART

Power converters are used for example as DC-DC converters as disclosed in US 7,333,348 B2. This document shows a full bridge switching circuit for driving a resonance circuit comprising a series inductor, a series capacitor, and a transformer. For improving switching efficiency, the MOSFET switches are turned on and off during current zero-crossing of the resonance circuitry. For increasing the power level, the MOSFETs shown must be replaced by more powerful IGBTs. Furthermore, zero-crossing switching makes control of power flow very difficult.

Another power converter which uses zero voltage switching technology to increase efficiency is disclosed in US 7,339,801 B2. This circuit offers good control of the power flow, but is difficult to implement using IGBTs for higher power levels. For increasing the switching power while maintaining good switching characteristics, a combination of IGBTs and FETs is disclosed in US 4,901,127.

Another approach for improving switching characteristics is the monolithic integration of punch-through IGBTs and non-punch-through IGBTs.

A specific application of power converters for contactless power transfer between rotating parts is disclosed in EP 13 37 001 A.

### SUMMARY OF THE INVENTION

It is a general object of the present invention to provide a power switch for power converters, a power converter using such a switch and a rotating power transmission device having an increased efficiency and higher power capability.

The problem is solved by the means as specified in the independent claims and the claims dependent thereon.

The power switch according to the invention comprises at least a first IGBT 1 and a second IGBT 2. The collectors of the IGBTs are connected together to a common collector line. The emitters of the IGBTs are also collected in parallel to a common emitter line. Furthermore, a control circuit 10 is provided for controlling the gates of the first and the second IGBTs. The first IGBT 1 is an IGBT with a comparatively low collector-emitter on voltage and comparatively high switching losses. The second IGBT 2 is an IGBT with comparatively high collector-emitter on voltage and comparatively low switching losses. The first IGBT may be of the field-stop (FS) type, while the second IGBT may be of the punch-through (PT) or the non-punch-through (NPT) type. A typical IGBT of the field-stop type is the APT100GN120J manufactured by Advanced Power Technology. A typical punch-through IGBT is the APT75GP120JDQ3 and a typical non-punch-through IGBT is the APT75GT120JRDQ3. The characteristic technical data of these IGBTs are shown in the table below.

| **IGBT Type** | **FS** | **PT** | **NPT** |
|---|---|---|---|
| VCEon | 1.7V | 3.4V | 3.4V |
| tr | 50ns | 40ns | 60ns |
| tf | 210ns | 110ns | 30ns |
| td(on) | 50ns | 20ns | 50ns |
| td(off) | 725ns | 245ns | 415ns |
| Eon | 12mJ | 1.5mJ | 8mJ |
| Eoff | 14mJ | 5mJ | 4mJ |

The VCEon is the collector-emitter on voltage under nominal load, for example 100 A. tr is the current rise time and tf is the current fall time. td(on) is the turn-on delay time and td(off) is the turn-off delay time. Eon is the turn-on switching energy and Eoff is the turn-off switching energy.

According to the invention, a control circuit 10 is provided for producing the gate control signals 21, 22 of the gates of the first and the second IGBTs. These gate control signals are referred to as the first common emitter 29. Herein the term on-signal is used for a positive voltage which switches the IGBT into an on state. The control signals have such timing that the IGBTs switch at different times during an on-time interval. According to the invention, the first IGBT having low collector-emitter on voltage must be on during times, when the load current has its maximum amplitude. These times are typically at the center of the on time interval. The second IGBT having higher collector-emitter on voltage but better switching characteristics is on during the whole on time interval, thus accomplishing the switching actions, as this IGBT switches on when the on time interval begins and switches off when the on time interval ends. When the first IGBT is on within the on time interval, it automatically carries the load current as it has the lower collector-emitter on voltage. This combination of two different IGBTs leads to a new switch having the good switching characteristics of the second IGBT and the good conducting characteristics of the first IGBT. Due to the good load characteristics of IGBTs this combination can switch much higher load currents and load voltages than the combination of an IGBT and a MOSFET. With up to date IGBTS voltages up to 1200V and currents of up to 400V can be handled in a single SOT-227 case.

The above table shows that typical PT and NPT IGBTs have twice the collector-emitter on voltage (VCEon) rating of the FS IGBT. Accordingly, the FS IGBT can carry the main load current better than a PT or a NPT IGBT. While the current rise times (tr) of all three IGBTs are in a similar range, there are significant differences in the current fall times (tf). While the PT IGBT has about half the current fall time of the FS IGBT, the NPT IGBT has lowest fall time of all IGBTs. Furthermore, there are significant differences in the turn-on switching energy (Eon) and the turn-off switching energy (Eoff). Here, the PT and NPT IGBTs offer best switching performance with lowest switching losses while even the NPT IGBT is better than the FS IGBT.

The term comparatively low collector-emitter on voltage and comparatively high collector-emitter on voltage are used to specify a difference between the collector-emitter on voltage rating VCEon of the first IGBT and the second IGBT. For obtaining the best effect of the invention, this difference should be more than 20 %, preferably 100 %. In the example of the above table, there is a 100 % difference. Accordingly, there is also a difference between the first IGBT and the second IGBT in current rise time tr / current fall time tf or the turn-on switching energy Eon / turn-off switching energy Eoff of at least 20 %, preferably 100 % or more. Furthermore the second IGBT may be selected with a lower continuous current rating than the first IGBT, as the second IGBT only carries the load current around the switching time intervals. Therefore a peak current rating of the second IGBT adapted to the switching currents may be sufficient. This can result in a smaller and therefore cheaper second IGBT.

In a preferred embodiment of the invention, the on-signal, which is delivered to at least one first IGBT 1 ends a predetermined first time before the on-signal to the at least one second IGBT 2 ends. This ensures that the first IGBT 1 has already switched off before the second IGBT 2 starts switching off. Preferably, this predetermined first time is at least the turn-off time of the first IGBT 1. In calculating this predetermined time, also the fall times and/or the turn-off delay times of the first IGBT 1 and/or the second IGBT 2 may be considered. Furthermore this predeterminied time should be long enough to allow the recombination of the minority carriers in the first IGBT. As during this recombination time the load current is carried by the second IGBT, the losses in the first IGBT are minimized and primarily the second IGBT determines the switching losses.

As the conducting and switching losses vary with the load conditions and the recombination time of the charge carriers with the temperature, the timing and specifically the predetermined first time can be changed by the control circuit (10) dependant on defined, measured or calculated parameters like switching frequency, current or temperature. The control circuit may determine a new predetermined first time for each switching cycle.

According to a further aspect of the invention the control circuit 10 is designed to deliver a on signal to the at least one second IGBT 2 and a on signal to at least one first IGBT 1 which ends a predetermined first time before the on signal to the at least one second IGBT 2 ends. This predetermined first time is preferably at least the turn off time of the at least one first IGBT 1. In calculating this predetermined time, also the fall times and/or the turn-off delay times of the first IGBT 1 and/or the second IGBT 2 may be considered. Furthermore this predeterminied time should be long enough to allow the recombination of the minority carriers in the first IGBT.

In a further embodiment of the invention, the on-signal delivered to the at least one first IGBT 1 starts a predetermined second time after the on-signal to the at least one second IGBT 2. In calculating this predetermined time, also the rise times and/or the turn-on delay times of the first IGBT 1 and/or the second IGBT 2 may be considered. This ensures that the at least one first IGBT 1 switches on after the at least one second IGBT 2 already has been switched on. This avoids the IGBT 1 taking the full switching load. Also here the predetermined second time can be changed by the control circuit (10) dependant on defined, measured or calculated parameters like switching frequency, current or temperature. The control circuit may determine a new predetermined second time for each switching cycle.

For the invention, it is essential that the first IGBT 1 carries the main current load, while the second IGBT 2 performs the switching operation and is switched on first and switched off last.

Another aspect of the invention relates to a power converter which comprises at least one of the beforementioned embodiments. Such a power converter is, for example, a switch mode power supply, a drive controller for generating pulsed currents for electrical motors, an inverter for a welding apparatus, a solar power inverter or any other device, which uses pulsed electrical signals for electrical energy conversion.

Such a power converter may be a simple hard switching converter, it may also be based on a resonance circuit or it may be based on a zero-voltage transition or zero-current switching technology.

In another aspect of the invention, a contactless rotary joint has a rotating power transformer and at least one generator for generating pulsed or AC electrical signals from a DC input signal. This circuit employs according to the invention at least one semiconductor power switch according to one of the previous embodiments. A contactless rotary joint according to the invention is very similar to a switch mode power supply, where the power transformer is replaced by a rotating transformer.

### BRIEF DESCRIPTION OF THE DRAWINGS

In the following the invention is described by way of example without limitation of the general inventive concept with the aid of embodiments and with reference to the drawings to which attention is expressly drawn concerning a disclosure of details of the invention not described more explicitly in the text.
Fig. 1 shows a power converter according to the invention.
Fig. 2 shows a semiconductor power switch according to the invention.
Fig. 3 shows a further embodiment of a power converter.
Fig. 4 shows a simple power converter as known from prior art.
Fig. 5 shows a timing diagram of a power converter.
Fig. 6 shows a timing diagram of the invention.
Fig. 7 shows a timing diagram of a preferred embodiment.
Fig. 8 shows a detailed diagram explaining the switching characteristics.
Fig. 9 shows a plot of a measured device.
Fig. 10 shows the plot of Fig. 9 in a different scale.

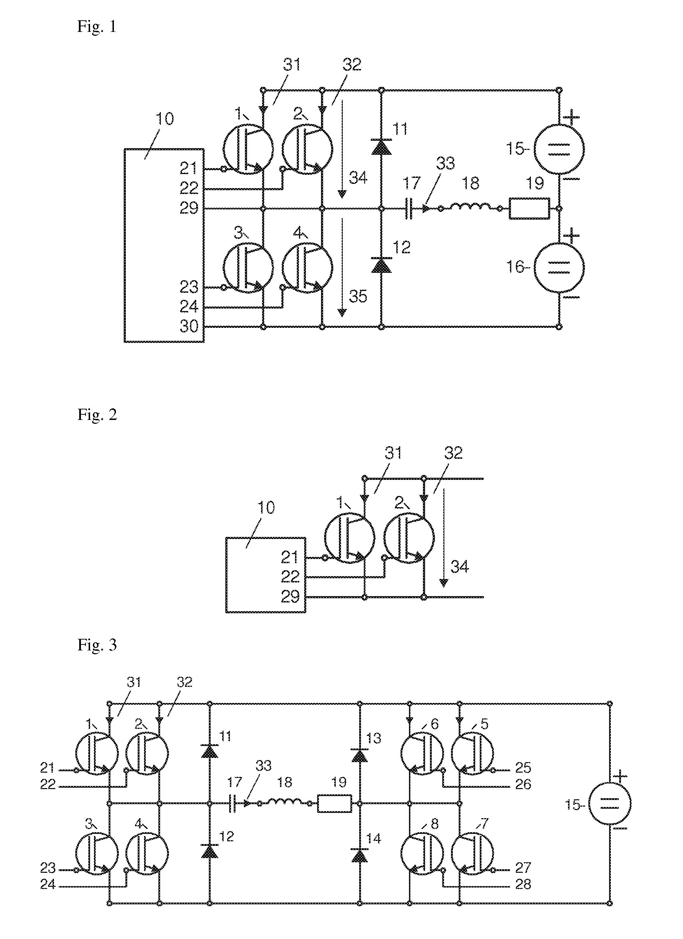

In Fig. 1, a power converter according to the invention is disclosed. It comprises a first pair of IGBTs comprising of the first IGBT 1 and the second IGBT 2. The second pair of IGBTs comprises the first IGBT 3 and the second IGBT 4. Within each pair of IGBTs, the collectors are connected together and the emitters are also connected together. In parallel to each of the IGBT pairs, a diode 11, 12 is connected with reversed polarity. Power is delivered by a series circuit of a first DC power source 15 and a second DC power source 16. Such a power source typically is the line input from an AC power line rectified by a bridge rectifier and optionally filtered by a parallel capacitor. The positive output of the first power source 15 is connected to the collectors of the first pair of IGBTs. The negative output of the first power source is furthermore connected to the positive output of the second power source 16. The negative output of the second power source 16 is connected to the emitters of the second pair of IGBTs. The emitters of the first pair of IGBTs are connected to the collectors of the second pair of IGBTs. Furthermore, this line is connected to the diodes 11 and 12 and the load circuit comprising a resonance capacitor 17, a resonance inductor 18 and a resistive load 19, which is again connected to the center connection of the negative output of the first DC power source and the positive output of the second power source. The load circuit shown herein is only one exemplary embodiment of a load circuit. It is understood that every other load circuits according to state of the art may be used herein. A series resonance circuitry as shown simplifies explanation of operation of the circuit. The sequence of the parts may be exchanged, as this has no influence on the circuit. Typically, instead of the series inductor, a transformer is used. A control circuit 10 is provided for gate voltages or gate signals to the gates 21, 22 of the first pair of IGBTs and to the gates 23, 24 of the second pair of IGBTs. The gate voltage of the gates of the first pair of IGBTs is referred to the emitter line 29 of the first pair of IGBTs, where the gate signals of the second pair of IGBTs refers to the emitter line 30 of the second pair of IGBTs. For further reference, the current 31 flowing into the first IGBT 1, the current 32 flowing into the second IGBT 2, and the load current 33, as well as the voltage 34 across the first pair of IGBTs and the voltage 35 across the second pair of IGBTs are marked.

In Fig. 2, a semiconductor power switch according to the invention is shown. Again, there are a first IGBT 1 and a second IGBT 2, switched parallel by the emitters and the collectors. The control circuit 10 supplies a first IGBT gate signal 21 and a second IGBT gate signal 22, both signals referring to the emitter line 29 of the parallel circuit. For later reference, the current 31 flowing into the first IGBT 1, the current 32 flowing into the collector of second IGBT 2, and the voltage across the collectors and emitters of the IGBTs are marked.

In Fig. 3, another embodiment of the invention is shown. Here, a full H-bridge is shown with four pairs of IGBTs, the first pair comprising of IGBTs 1 and 2, the second pair comprising of IGBTs 3 and 4, the third pair comprising of IGBTs 5 and 6, and the fourth pair comprising of IGBTs 7 and 8. One freewheeling diode 11, 12, 13, 14 is provided in reverse direction parallel to each pair of the pairs of IGBTs. Between the first and the second pair of IGBTs and the third and fourth IGBTs, there are the series resonance and load circuit elements resonance capacitor 17, resonance inductor 18, and load resistor 19. This circuit is fed by a single DC power source 15, which positive output is connected to the collectors of the first and third pair of IGBTs, while the negative output is connected to the second and fourth pair of IGBTs.

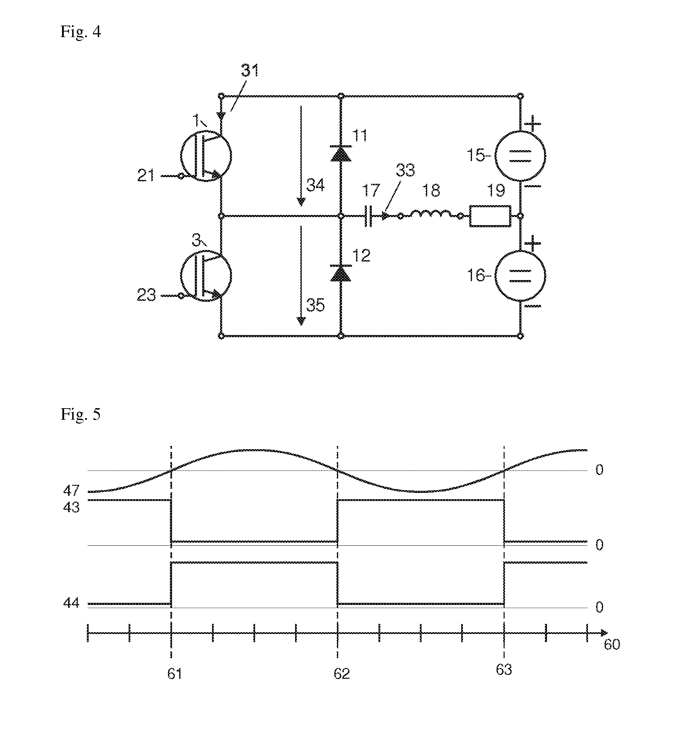

In Fig. 4, a circuit according to the prior art is shown. The emitter of IGBT 1 is connected to collector of IGBT 3. Emitter of IGBT 3 is connected to the negative output of DC power source 16. The collector of IGBT 1 is connected to positive output of power source 15. Negative output of power source 15 and positive output of power source 16 are connected together and form a center line. Parallel, but with reverse polarity, there are diodes 11 and 12 connected to the IGBTs 1 and 3. Furthermore, the load circuit comprising of the series resonance capacitor, the resonance inductor and the load is connected between the emitter of the first IGBT, the collector of the second IGBT and the center point between the two DC power sources.

Fig. 5 shows the basic timing diagram of a push-pull stage according to the invention and also according to prior art (Fig. 1 and Fig. 4). Line 47 shows the timing diagram of the load current 33 in resonance condition. This load current through the series resonance circuit is approximately a sinusoidal wave form with changing positive and negative polarity. Curve 43 shows the timing of the voltage 34 between collector and emitter of the IGBTs 1 and 2. Curve 44 shows the voltage 35 between collector and emitter of IGBTs 3 and 4. At a positive current 47, during a first time interval between the times 61 and 62 the voltage 34 across the first pair of IGBTs is zero, while during a second time interval between the times 62 and 63 the voltage 34 across the first pair of IGBTs is approximately equal to the sum of of the voltages of the first DC power source 15 and the second DC power source 16. During the first time interval the emitters of the first pair of IGBTs are connected to the positive output of power source 15. During that time, the full voltage as delivered by the DC power sources 15 and 16 is across the second pair of IGBTs. Accordingly, the first pair of IGBTs has to be in a conducting (on) state, while the second pair of IGBTs is in a high impedance (off) state. The timing intervals between the individual ticks at the time axis 60 may, for example, be 5 µs. Accordingly, the half wave between the marks 61 and 62 takes 20 µs, while the full period between the marks 61 an 63 is 40 µs.

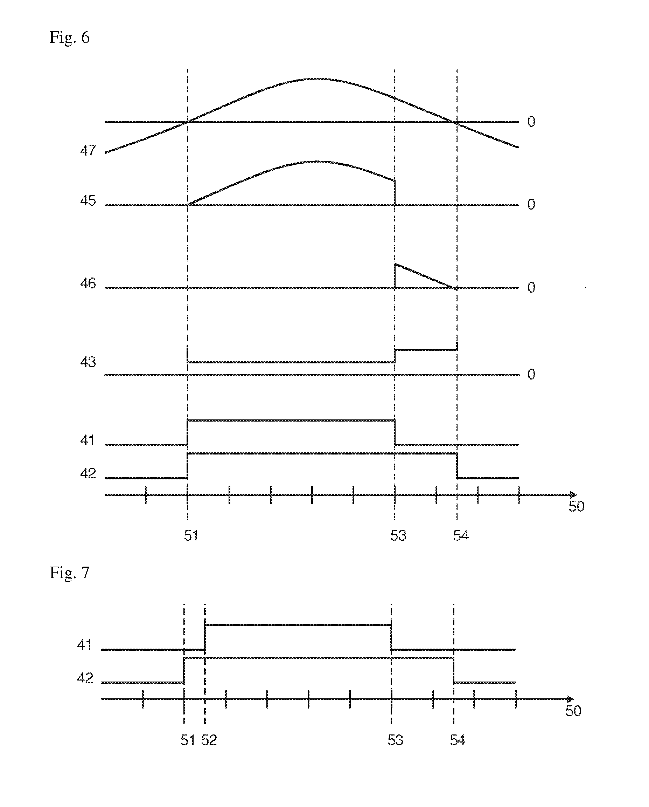

Fig. 6 shows in more detail the timing of the invention. Again, in curve 47, the timing of the load current is shown. Here, only the timing of a positive half wave is explained, as the negative half wave is very similar. Instead of the first pair of IGBTs, switching is done during the negative half wave by the second pair of IGBTs. Curve 41 shows the timing of the voltage between first IGBT gate 21 and the emitter, while curve 42 shows the voltage between the second IGBT gate 22 and the emitter. Essential for the invention is, that the gate voltage applied to an IGBT is selected such that the IGBTs can be switched on or off as required. Typical gate voltages for switching IGBTs on are in the range of 8V to 40V, while the off voltages are in a range of 1V to -40V. At zero-crossing of the current, which occurs at the time mark 51 on the time axis 50, the first IGBT 1 and the second IGBT 2 receive their on gate signals at the same time. As the turn-on delay time and the rise time of the first IGBT is longer than the turn-on delay time and the rise time of the second IGBT, the first IGBT will take the switching with its lower switching losses, while IGBT 1 starts later carrying the load current. As the time difference here is very small, it is not displayed in the diagram. Except from this preferred embodiment, the invention would also work if even both IGBTs would switch at exactly the same time or even if IGBT 1 would switch before IGBT 2, resulting in higher switching losses. In practice, another positive delay of switching IGBT 1 later than IGBT 2 is caused by the typical switch-on delay, which is bigger at IGBT types according to IGBT 1. Curve 43 shows the voltage 33 between collector and emitter of the first pair of IGBTs. As in this curve only a voltage in a range of some volts is shown, the full curve with the voltage for the case the IGBTs are open, which is typically several hundred volts, is not shown. Accordingly, the curve is truncated. When switching on the IGBTs, the voltage 34 drops to a comparatively low value according to the low collector-emitter on voltage of the first IGBT. In this case, the first IGBT and the second IGBT are on. As the first IGBT has a significant lower collector-emitter on voltage than the second IGBT, the first IGBT will carry most of the load current, as shown in curve 45, which shows the collector current 31 of the first IGBT. At a later time 53, some period before the current zero crossing time 54, the IGBT 1 gate voltage 21 is switched to a low level close to zero volts or even some negative value to switch IGBT 1 off. When IGBT 1 is switched off, the current through IGBT 1 as shown in curve 45 goes to zero, while the current starts flowing through IGBT 2, as shown in curve 46. As IGBT 2 has a higher collector-emitter on voltage than IGBT 1, the voltage 34 increases, for example, from 1.7 volts to 3.4 volts, as shown in curve 43. At the time of current 33 zero-crossing according to curve 45 at time 54, the second IGBT is also switched off by setting the gate drive signal to zero. At this time, the second IGBT performs the switching action with low switching losses. From Fig. 6 it is obvious that the inventive combination of two different IGBTs together with the appropriate timing combines the positive features of the two IGBTs, low loss during the conductive phase and low switching losses. According to the invention the stacked timing of switching the IGBTs may be either applied for switching the load on or off or both.

In Fig. 7, a further embodiment is shown. Here again, the curve 41 is showing the gate voltage 21 of first IGBT 1, and curve 42 is showing gate voltage of the second IGBT 2. Here, the first gate voltage as shown in curve 41 is switched on with some delay against the second IGBT gate voltage, so that in any case the second IGBT takes the switching action and the first IGBT takes over the current after the first IGBT has switched on.

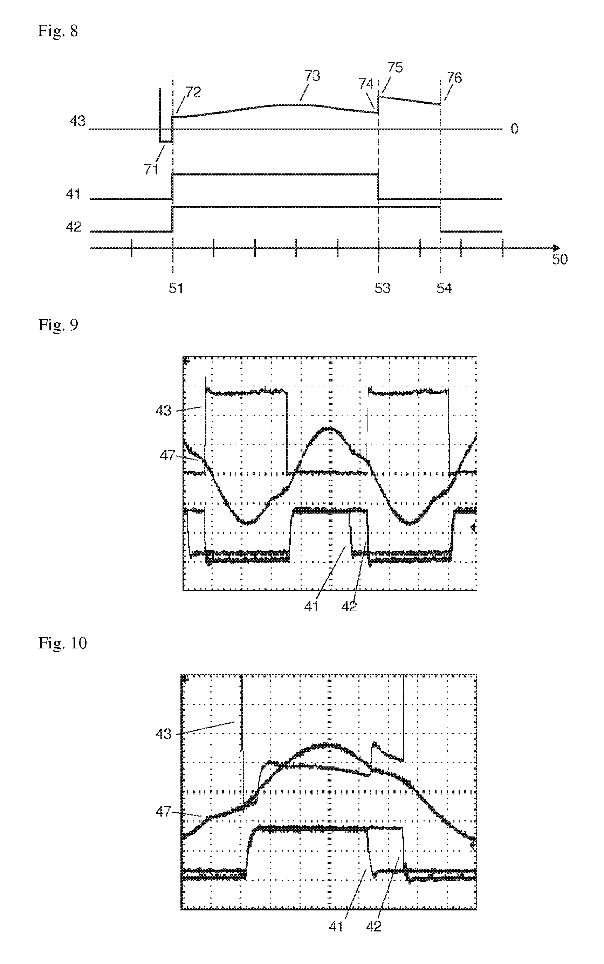

In Fig. 8, the voltage 34 between collector and emitter of IGBTs 1 and 2 is shown in more detail. For reference, again the gate voltage 22 is shown in curve 42 and the gate voltage 21 is shown in curve 41. In this case, load current zero-crossing is a small amount of time before marker 51 at the switching on time of both IGBTs. As the current is already positive, but the first pair of IGBTs is in an off-state, the diode 11 will carry the whole load current, resulting in a slightly negative voltage 71 across the IGBTs. Later, when the IGBTs take over the load current, voltage 34 shown in curve 43 starts with the minimum collector-emitter on voltage of the IGBT 1, when taking over the current. As the voltage drop across, IGBT 1 also has to pass some resistance, the voltage drop across IGBT 1 increases with load current. Accordingly, there is a slightly sinusoidal curve of the voltage drop on this IGBT, resulting in a maximum voltage drop at the maximum amplitude of current flowing through the IGBTs. When IGBT 1 is switched off at time 53, the lower voltage drop 74 of the first IGBT switches over to the higher voltage drop 75 of the second IGBT. As the current decreases with time, the voltage drop also decreases down to the minimum collector-emitter on voltage of IGBT 2 76 at switching off time 54.

In Fig. 9, a plot of a measured circuit is shown. This plot is similar to a combination of Figs. 5 and 6 showing the voltage 34 between collector and emitter of IGBTs 1 and 2 together with the load current 33 and the first IGBT gate voltage 21 in curve 41 and the second IGBT gate voltage 22 in curve 42.

Fig. 10 is very similar to Fig. 9 except a slightly enlarged timing scale and an enlarged scale of the curve 43, showing details as the curve 43 in Fig. 8 does.

### List of Reference Numerals

- 1, 3, 5, 7: first IGBTs
- 2, 4, 6, 8: second IGBTs
- 10: control circuit
- 11, 12, 13, 14: diodes
- 15, 16: DC power sources
- 17: resonance capacitor
- 18: resonance inductor
- 19: load
- 21, 23, 25, 27: first IGBTs gate signal input
- 22, 24, 26, 28: second IGBTs gate signal input
- 29: first common emitter
- 30: second common emitter
- 31: first IGBT 1 collector current
- 32: second IGBT 2 collector current
- 33: load current
- 34: voltage between collector and emitter of IGBTs 1, 2
- 35: voltage between collector and emitter of IGBTs 3, 4
- 41: timing diagram of voltage between first IGBT gate 21 and emitter
- 42: timing diagram of voltage between second IGBT gate 22 and emitter
- 43: timing diagram of voltage 34 between collector and emitter of IGBTs 1, 2
- 44: timing diagram of voltage 35 between collector and emitter of IGBTs 3, 4
- 45: timing diagram of first IGBT 1 collec- tor current 31
- 46: timing diagram of second IGBT 2 collec- tor current 32
- 47: timing diagram of load current 33
- 50: time axis
- 51: first switching on time
- 52: second switching on time
- 53: first switching off time
- 54: second switching off time
- 60: time axis
- 61, 62, 63: times related to resonance circuit cycles
- 71: forward voltage level of diode 11
- 72, 73, 74: collector - emitter on voltage of IGBT 1
- 74,76: collector - emitter on voltage of IGBT 2

## Claims

1. Semiconductor power switch comprising of at least one first IGBT (1) and at least one second IGBT (2), wherein the collectors of both IGBTs and also the emitters of both IGBTs are connected to each other, both IGBTs receive gate signals from a control circuit (10) for switching the power switch on during a first time interval and off during a second time interval,
**characterized in that,**
the at least one first IGBT (1) is an IGBT type with comparatively low collector-emitter on voltage and comparatively high turn on or turn off switching energy, the at least one second IGBT (2) is an IGBT type with comparatively high collector-emitter on voltage and comparatively low turn on or turn off switching energy, and the control circuit (10) is designed to deliver a on signal to the at least one second IGBT (2) during the whole first time interval and a on signal to at least one first IGBT (1) during only parts of the first time interval.

2. Device according to claim 1,
**characterized in that,**
the on signal delivered to the at least one first IGBT (1) ends a predetermined first time, which is at least the turn off time of the at least one first IGBT (1), before the on signal to the at least one second IGBT (2) ends.

3. Semiconductor power switch comprising of at least one first IGBT (1) and at least one second IGBT (2), wherein the collectors of both IGBTs and also the emitters of both IGBTs are connected to each other, both IGBTs receive gate signals from a control circuit (10) for switching the power switch on during a first time interval and off during a second time interval,
**characterized in that,**
the at least one first IGBT (1) is an IGBT type with comparatively low collector-emitter on voltage and comparatively high turn on or turn off switching energy, the at least one second IGBT (2) is an IGBT type with comparatively high collector-emitter on voltage and comparatively low turn on or turn off switching energy, and the control circuit (10) is designed to deliver a on signal to the at least one second IGBT (2) and a on signal to at least one first IGBT (1) which ends a predetermined first time, which is at least the turn off time of the at least one first IGBT (1), before the on signal to the at least one second IGBT (2) ends.

4. Device according to claims 2 or 3,
**characterized in that,**
the predetermined first time is set according to an estimated, measured or pre-set load condition like load current, switching frequency or a temperature.

5. Device according to any one of the preceding claims,
**characterized in that,**
the on signal delivered to the at least one first IGBT (1) starts a predetermined second time, which is at least the turn on time of the at least one second IGBT (2), after the on signal to the at least one second IGBT (2) starts.

6. Device according to claim 5,
**characterized in that,**
the predetermined second time is set according to an estimated, measured or pre-set load condition like load current, switching frequency or a temperature.

7. Power converter **characterized by** in at least one semiconductor power switch according to any one of the preceding claims for generating an AC signal which can be coupled over a transformer.

8. Contactless rotary joint having a rotating power transformer and at least a semiconductor power switch according to any one of the preceding claims for generating an AC signal which can be coupled over the transformer.
